# EUROPÄISCHE PATENTSCHRIFT

(11) **EP 1 620 946 B1**
(45) Veröffentlichungstag und Bekanntmachung des Hinweises auf die Patenterteilung: **26.03.2008**
(21) Anmeldenummer: 04728116.7
(22) Anmeldetag: 17.04.2004
(51) Int. Cl.: H03K 3/537, H02M 7/26

(54) **TRIGGER-/ZÜNDEINRICHTUNG IN EINEM AUS N STUFENKONDENSATOREN BESTEHENDEN MARX-GENERATOR**
TRIGGER / IGNITION DEVICE IN A MARX GENERATOR PROVIDED WITH N STEP CAPACITORS
DISPOSITIF DE DECLENCHEMENT/D'ALLUMAGE DANS UN GENERATEUR DE MARX COMPORTANT N CONDENSATEURS A CASCADE

(30) Priorität: 08.05.2003 DE 10320425
(43) Veröffentlichungstag der Anmeldung: 01.02.2006
(73) Patentinhaber: Forschungszentrum Karlsruhe GmbH, 76133 Karlsruhe (DE)
(72) Erfinder: SACK, Martin, 76287 Rheinstetten (DE)
(74) Vertreter: Rückert, Friedrich
(86) Internationale Anmeldenummer: PCT/EP2004/004101
(87) Internationale Veröffentlichungsnummer: WO 2004/100371

(56) Entgegenhaltungen:
- US-A- 3 229 124
- US-A- 3 260 865
- US-A- 3 746 881
- US-A- 3 845 322
- US-A- 4 375 594
- US-A- 5 153 460

## Beschreibung

Die Erfindung betrifft eine Trigger-/Zündeinrichtung an einem aus n Stufenkondensatoren - n ist natürlich und größer 1 - gleich vielen Schaltern/Funkenstrecken und 2(n-1) Ladezweigen bestehenden Marx-Generator, dessen Funkenstrecken im Selbstdurchbruch arbeiten. Er hat bei unipolarer Ausgangsspannung üblicherweise genauso viele Funkenstrecken wie Stufenkondensatoren. Im einfachsten Aufbau arbeiten die Funkenstrecken im Selbstdurchbruch. An jeder Funkenstrecke, bis auf die ausgangsseitige, setzen zwei Ladezweige an, und zwar einer an jedem der beiden Anschlüsse der Funkenstrecke. Damit gibt es die insgesamt 2(n - 1) Ladezweige an einem n-stufigen Marx-Generator. Bei einer Ladespannung U an jedem der Stufenkondensatoren ergibt sich dann am Ausgang des Marx-Generators beim Durchbruch einen Spannungsimpuls mit einem Scheitelwert von n*U.

Gesteuert durchzündbare Marx-Generatoren haben entweder Dreielektroden-Funkenstrecken oder Funkenstrecken mit einem Zündstift ähnlich einer Zündkerze, auch bekannt als Trigatron-Prinzip. Solche Marxgeneratoren werden meist im Einzelpulsbetrieb betrieben. Zur Triggerung repetierend betriebener Marx-Generatoren wird versucht, Funkenstrecken nach den genannten Prinzipien hinsichtlich eines geringen Abbrands zu minimieren (siehe /1/) oder die Triggerung durch optimierte Zündgeneratoren betriebssicherer zu machen (siehe /2/). Ferner werden auch Methoden zur Lasertriggerung (siehe /3/) oder zum Einsatz von Halbleiterschaltern statt Funkenstrecken (siehe /4/) untersucht. Eine andere Triggermöglichkeit besteht in der Spannungsinversion, Prinzip des LC-Marx-Generators. In /5/ ist eine Variante dieses Prinzips beschrieben, bei der Transformatoren zur Kopplung zwischen den Stufen eingesetzt werden. Daneben beschäftigen sich Arbeiten mit der Optimierung des Selbstdurchbruchs von Funkenstrecken für den freilaufenden Betrieb (siehe /6/).

Die Zündelektroden in triggerbaren Funkenstrecken sind aufgrund ihrer exponierten Lage einer erhöhten Beanspruchung ausgesetzt. Darüber hinaus ist der mechanische Aufbau einer triggerbaren Funkenstrecke aufwendiger als der einer Funkenstrecke, die im Selbstdurchbruch betrieben wird.

Der Erfindung liegt die Aufgabe zugrunde, repetierend betriebene Marx-Generatoren verschleißarm im Selbstdurchbruch ihrer Funkenstrecken zu festgelegten Zeitpunkten gezielt durchzuzünden, insbesondere mit Blick auf den repetierenden Betrieb.

Die Aufgabe wird durch eine Trigger-/Zündeinrichtung gemäß den kennzeichnenden Merkmalen des Anspruchs 1 gelöst.

Die Trigger-/Zündeinrichtung besteht grundsätzlich aus mindestens einem an einen Impulsgenerator angeschlossenen Impulsübertrager. In mindestens einem der Ladezweige des Marx-Generators, welcher mit dem zugeordneten Stufenkondensator eine Funkenstrecke - außer der am Marx-Generator ausgangsseitigen Funkenstrecke- überbrückt, sitzt ein solcher Impulsübertrager. Die Ausgangswicklung oder Sekundärwicklung oder oberspannungsseitige Wicklung des Übertragers wirkt während des Ladens als oder mit als Ladespule/-induktivität. Die Eingangswicklung oder Primärwicklung oder unterspannungsseitige Wicklung des Impulsübertragers ist an den Ausgang des Impulsgenerators angeschlossen. Beim Zünden/Triggern des Impulsgenerators wird in der Ausgangswicklung des Impulsübertragers ein Spannungsimpuls erzeugt, der zur Ladespannung des zugeordneten Stufenkondensators addiert und bei entsprechender Polung während des Anstiegs des Spannungsimpulses kurzzeitig eine zum Selbstdurchbruch reichende Überspannung an dieser Funkenstrecke erzeugt.

In den Unteransprüchen 2 bis 13 sind mögliche Ausführungsformen der Einrichtung zur Triggerung der Funkenstrecke/-n beschrieben, die einerseits das sichere Durchzünden des Marx-Generators bewirken und andrerseits den Aufbau wirtschaftlich ermöglichen.

Der Marx-Generator kann auf zweierlei Art aufgebaut sein, je nach dem ob er für den repetierenden oder Einzelschussbetrieb verwendet wird. Für den repetierenden Betrieb hat sich nach Anspruch 2 bewährt, in die Ladezweige eine Ladespule zu setzen und wenigstens eine dieser Ladespulen zum Impulsübertrager zu ergänzen. Um den elektrischen Isolationsaufwand in Grenzen oder gering zu halten, sitzt zumindest am erdseitigen Ladezweig eine solche zum Impulsübertrager ergänzte/erweiterte Ladespule.

Wird der Marx-Generators über Ladewiderstände aufgeladen, dann sitzt in mindestens einem Ladezweig ein Impulsübertrager. Seine Ausgangswicklung ist dann wahlweise direkt in Reihe oder parallel zum Ladewiderstand (Anspruch 3).

Beim Marx-Generator sind alle Funkenstrecken bis auf die ausgangsseitige zweimal durch einen Ladezweig und zugeordnetem Stufenkondensator überbrückt. An beiden Anschlüssen einer Funkenstrecke setzt stets ein Ladezweig an. Nach Anspruch 4 ist die Trigger-/Zündeinrichtung so ausgestaltet, dass in die beiden Ladezweige je einen Impulsübertrager eingebaut ist. Grundsätzlich kann das an jeder der (n - 1) Funkenstrecken sein, wiederum, um den Isolationsaufwand begrenzt zu halten, vorteilhafterweise an der potentialmäßig untersten Funkenstrecke.

Nach Anspruch 5 sind die Eingangswicklungen der beiden Impulsübertrager zueinander elektrisch in Reihe und sind an einen gemeinsamen Impulsgenerator angeschlossen. Nach Anspruch 6 liegen sie zueinander parallel am Impulsgenerator. Aufwendiger nach Anspruch 7 ist jede Eingangswicklung an ihren eigenen Impulsgenerator angeschlossen.

Der oder die Impulsgeneratoren können unterschiedlich angesteuert werden. Nach Anspruch 8 elektrisch oder nach Anspruch 9 jeweils über eine Lichtleitfaser. In letzterem Fall sind zumindest die Impulsübertrager in ihrem Isolationsaufbau alle gleich. Hat jeder Impulsübertrager einen eigenen Impulsgenerator, dann sind die Baueinheiten: Impulsübertrager - Impulsgenerator, isolationstechnisch an jeder Stufe gleich. Impulsgenerator und die angeschlossene/n Eingangswicklung/en können unterschiedlich aufgebaut sein. Nach Anspruch 10 einmal als eine schnell abschaltbare Stromquelle, nach Anspruch 11 als eine Spannungsquelle. Im ersteren Fall kann der Schalter ein Schalttransistor oder können Schalttransistoren sein, wie das beispielsweise in der transistorisierten Zündanlage eines Otto-Motors verwendet wird. In letzterem Fall liegt zur Strombegrenzung im Ladezweig noch eine Drosselspule in Reihe zur Ausgangswicklung am Impulsübertrager.

Als Spannungsquelle kann beispielsweise ein Kondensator mit Schalter (Anspruch 12) oder für große Leistungen sogar selbst ein in der Leistung gegenüber dem zu betreibenden Marx-Generator kleiner Marx-Generator (Anspruch 12) verwendet werden.

Zur Unterstützung der elektrischen Betriebssicherheit ist der Wickelsinn der eingangsseitigen Wicklung am Impulsübertrager so angelegt, dass die durch den Anstieg des Entladestromes des Marx-Generators in der Eingangswicklung induzierte Spannung der durch die Ausgangswicklung nach dem Prinzip des Transformators induzierten Spannung entgegengerichtet ist (Anspruch 13).

Die Vorteile einer der beschriebenen Einrichtungen liegen gegenüber einer herkömmlichen Triggermethode einerseits in einem einfachen, sparsamen Aufbau und andererseits in einem wesentlich geringeren Verschleiß als bei herkömmlichen Dreielektroden-Funkenstrecken. Damit kann ein Marxgenerator für eine Anlage bereitgestellt werden, welche ein langzeitlich konstantes Betriebsverhalten hat. Für einen zuverlässigen Betrieb im industriellen Einsatz ist das unerlässlich.

Die Einrichtung zur Triggerung mindestens einer im Selbstdurchbruch betriebenen Funkenstrecke an einem mehrstufigen Marxgenerator wird anhand der Zeichnung näher erläutert. Die Zeichnung besteht aus drei Figuren, die jeweils zeigen:
Figur 1 Marxgenerator mit Überspannungstriggerung der ersten Funkenstrecke;
Figur 2 Überspannungstriggerung mit Übertragern in beiden Ladezweigen;
Figur 3 Versorgung der Triggerschaltung aus dem Ladestrom;
Figur 4 beispielhafter Verlauf der Trigger-Überspannung (100ns/Div., 2,5 kV/Div.).

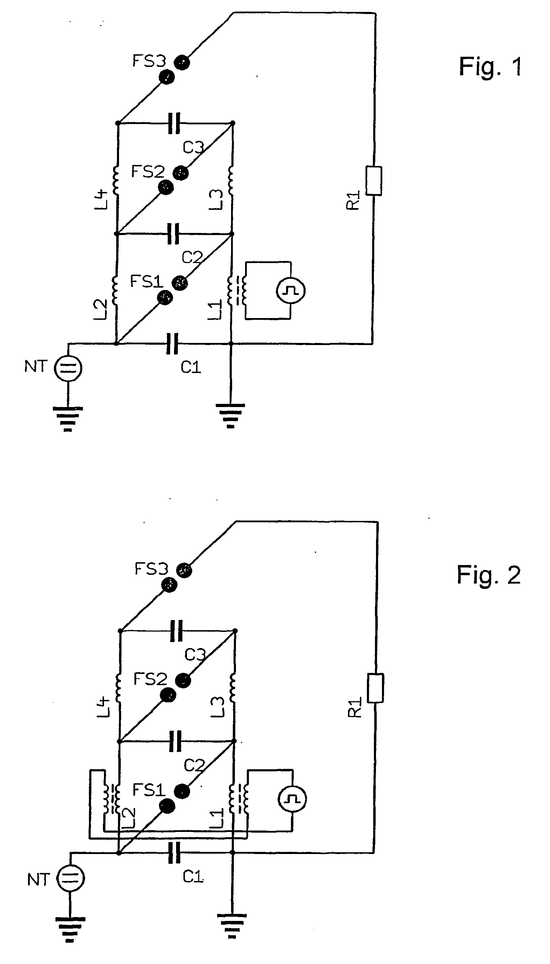

Bei der im folgenden beschriebenen Anordnung wird der Durchbruch der ersten Funkenstrecke FS1 des hier beispielsweise dreistufigen Marx-Generators durch eine kurzzeitig anliegende Überspannung erreicht. Der hier vorgestellte Marxgenerator ist für den repetierenden Betrieb und deshalb mit den Ladespulen L1 bis L4 bestückt, die während der Aufladephase die Kondensatoren C1 bis C3 parallel schalten (siehe Figuren 1 bis 3). Hierbei ist beispielsweise die erdseitige Ladespule L1 zum Impulsübertrager ergänzt. Die durch diesen Übertrager erzeugte Spannung addiert sich zur Ladespannung des Kondensators der ersten Stufe und erzeugt bei geeigneter Polung die Überspannung an der Funkenstrecke FS1 dieser Stufe. Die Überspannung verhilft also zeitlich gezielt zum Selbstdurchbruch der Funkenstrecke FS1.

Als Primär- oder Eingangswicklung des Impulsübetragers L1 dient eine aus wenigen Windungen bestehende Wicklung. Bei einer primären Pulsspannung geeigneter Höhe, hier beispielsweise 6 kV, zündet der Marx-generators reproduzierbar unterhalb seiner statischen Zündspannung durch.

Bei der Einspeisung über die Ladespule L1 ist der Funkenstrecke FS1 über dem Kondensator C2 die Ladespule L2 parallel geschaltet. Der so gebildete induktive Spannungsteiler, bestehend aus der Ladespule L2 und der Streuinduktivität des Impulsübertragers L1 bei vernachlässigbar großer Kapazität des Ladekondensators C2, verringert die Spannung über der Funkenstrecke gegenüber dem Leerlauffall. Dementsprechend muss mit höherer Primärspannung als beim Leerlauffall gespeist und die Ladespule L2 mit möglichst großer Induktivität ausgeführt werden. Andererseits kann bei kleiner Quellenimpedanz des Triggerpulsgenerators die Streuinduktivität von L1 nicht beliebig verkleinert werden, weil sonst nach dem Zünden des Marxgenerators ein erhöhter Strom durch L1 und den angeschlossenen Triggerimpulsgenerator fließen würde.

Um mit möglichst geringer Leistung bei der Triggerung auszukommen, ist es angebracht, auch die Ladespule L2 zu einem Impulsüberrtrager L2 zu erweitern (siehe Figur 2). Dazu wird der Zündimpuls durch geeignete primärseitige Serien- oder Parallelschaltung (Anspruch 4 oder 5) gleichzeitig und mit gleicher Polarität in beide Zweige eingespeist. Da beide Zweige bis zum Zünden der Funkenstrecke FS1 stromlos sind - bis auf den kleinen Ladestrom der Streukapazitäten -, wird die Spannung über der Funkenstrecke FS1 nicht wie im ersten Fall um den induktiven Spannungsabfall an der Streuinduktivität des Impulsübertragers L1 reduziert. Ein Nachteil dieser Schaltungsvariante liegt allerdings im höheren Isolationsaufwand für den Impulsübertrager L2, der zusätzlich für die Stufenspannung zu isolieren ist.

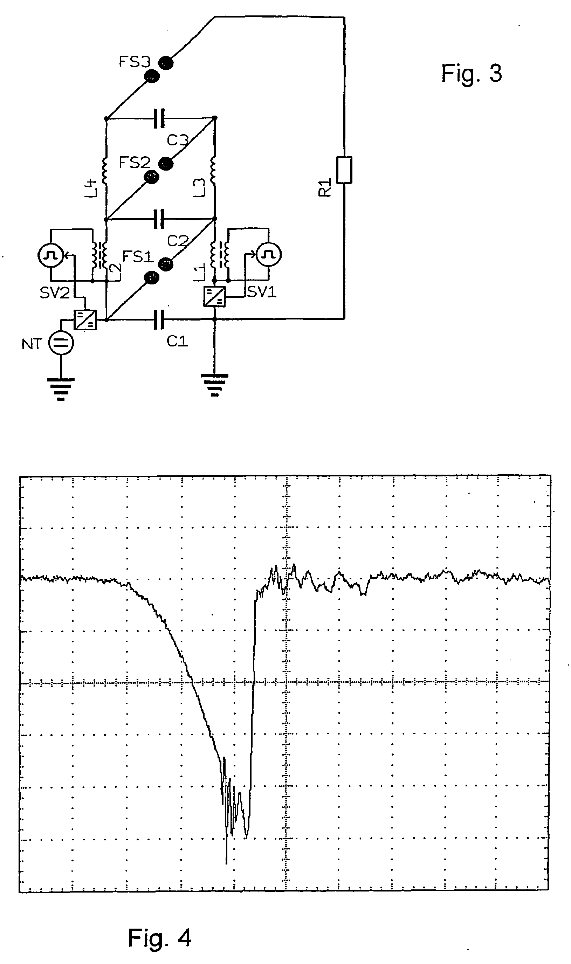

Der erhöhte Isolationsaufwand kann vermieden werden, wenn der Ladestrom des Marxgenerator zur Speisung der Triggereinheit genutzt wird. Dazu wird während des Ladens die Energie für mindestens den nächsten Triggerimpuls in einem geeigneten Energiespeicher, vorzugsweise einem Kondensator, zwischengespeichert. Figur 3 zeigt die Anordnung. Die Spannungsversorgung kann dabei wahlweise in Serie mit der zugeordneten Ladespule L1 oder in den benachbarten Zweig, wie bei SV2 gezeigt, geschaltet werden. Im Gegensatz zur Speisung aus einer im Betrieb nicht nachladbaren Batterie kann somit ein wartungsfreier Betrieb realisiert werden. Die Auslösung erfolgt aus isolationstechnischen Gründen zweckmäßigerweise mit einem Lichtsignal durch den verbindenden Lichtwellenleiter. Die Triggereinheit, bestehend aus Spannungsversorgung, Impulsgenerator und Spule, kann dann einfach in jede beliebige Stufe des Marxgenerators integriert werden. So ist auch der einfache Einbau mehrerer Trigger möglich, um das Durchzündverhalten des Generators, insbesondere bei größerer Stufenzahl, in ein engeres Zeitfenster zu zwingen.

Der in den Figuren 1 bis 3 skizzierte, dreistufige Marx-Generator ist Beispiel, er ist bei einer Nenn-Stufenspannung von 50 kV auf eine Summenladespannung von 150 kV ausgelegt. Der Fußpunkt des Marx-Generators an C1 ist geerdet. Als Last wird hier der ohmsche Lastwiderstand R1 angenommen. Die in der Realität üblicherweise nicht zu vernachlässigende aufbaubedingte Induktivität des Hauptstromkreises, gebildet aus der Serienschaltung von durchgeschaltetem Generator und Last, ist für die folgenden Betrachtungen irrelevant, auf sie wird daher nicht weiter eingegangen:

Wie bei nach herkömmlichen Methoden getriggerten Marxgeneratoren ist die statische Durchbruchspannung der Funkenstrecken auf ca. 5-10% oberhalb der Ladespannung der einzelnen Stufen eingestellt. Die Einstellung erfolgt gemäß der Paschen-Kurve wie üblich durch Variation des Elektrodenabstands und/oder des Gasdrucks in der Funkenstrecke. Nach dem Durchzünden der drei Funkenstrecken FS1 bis FS3 sind die Kondensatoren C1 bis C3 in Serie an die Last R1 geschaltet, über die sie sich im Hauptstrompfad entladen. Stromschwache Nebenentladepfade führen über die Ladespulen L1 - L4. Der unterste Stufenkondensator C1 liegt auf Erdpotential als Bezugspotential. Während des Ladevorgangs werden alle drei Stufenkondensatoren C1, C2, C3 über das Netzteil NT auf die Stufenspannung von beispielsweise 50 kV über die Ladespulen L1 bis L4 mit einem ungeregelten anfangsbegrenzten Strom oder Konstantstrom von beispielsweise 300 mA aufgeladen. Für den Probebetrieb ist die Ausgangsspannung des Netzteils auf die Ladeendspannung von 50 kV begrenzt. Als Netzteil kann ein handelsübliches Kondensatorladegerät oder Gleichspannungsnetzteil verwendet werden. In Figur 1 wird an der zum Impulsübertrager erweiterten Ladespule zum Zünden an der Eingangswicklung bei Speisung aus einer Spannungsquelle ein Spannungsimpuls von einem Dachwert von beispielsweise ca. 6 kV, bei einer anderen Auslegung zur Speisung aus einer Stromquelle ein Stromimpuls der innerhalb von beispielsweise ca. 300 nsec von beispielsweise 120 A auf 0 A absinkt, gelegt, der an der Ausgangswicklung des Impulsübertrager, der Ladespule, einen bis zum Durchbruch der Funkenstrecke ansteigenden Spannungsimpuls erzeugt. Figur 4 gibt den Verlauf eines solchen Spannungsimpulses exemplarisch wieder, der Betrag der dynamischen Durchbruchspannung der Funkenstrecke beträgt hier 12,5 kV. Diese Messung erfolgte außerhalb des Marx-Generators während der Erprobung der Triggerschaltung. Aufgrund der Rückwirkung des verwendeten ohmsch/gedämpft-kapazitiven Messteilers ist der Spannungsanstieg bei dieser Messung langsamer als im Betrieb ohne angeschlossenen Messteiler. Im Labortestbetrieb sind die Funkenstrecken einfache Kugelfunkenstrecken, für den anspruchsvollen Betrieb in einer Industrieanlage, insbesondere wegen des langzeitlich konstanten Betriebsverhalten, würden die Kalotten der Funkenstrecken ein abbrandarmes Profil, ein Borda-Profil (siehe beispielsweise DE 102 03 649) beispielsweise, haben.

Die in diesem Ausführungsbeispiel gemachten Zahlenangaben beziehen sich auf eine konkrete Ausführung eines auf die beschriebene Weise getriggerten Marx-Generators. Prinzipiell lässt sich die neue Triggermethode auch auf Marxgeneratoren mit Stufenspannungen von wenigen kV bis zu einigen 100 kV und insbesondere auch mit höheren Stufenzahlen anwenden.

### Legende

/1/ McPhee et al.: The Design and Electrostatic Modelling of a High Voltage, Low Jitter Trigatron For Repetitive Operation, IEE, 1995
/2/ Wang et at.: A Compact Repetitive Marx Generator, IEEE, 1999.
/3/ Kellogg: A Laser-Triggered Mini-Marx For Low-Jitter High-Voltage Applications, IEEE, 1999
/4/ Frost et al.: Ultra-Low Jitter Repetitive Solid State Picosecond Switching, IEEE, 1999
/5/ Engel, Kristiansen : A Compact High Voltage Vector Inversion Generator, IEEE.
/6/ Turnbull et al.: The Repetitive Operation of a Sparc Gap Column, IEEE, 1997

## Patentansprüche

1. Trigger-/Zündeinrichtung an einem aus n Stufenkondensatoren - n ist natürlich und größer 1 - gleich vielen Schaltern/Funkenstrecken und 2(n-1) Ladezweigen bestehenden Marx-Generator, dessen Funkenstrecken im Selbstdurchbruch arbeiten,
**dadurch gekennzeichnet, dass**:
die Trigger-/Zündeinrichtung aus mindestens einem an einen Impulsgenerator angeschlossenen Impulsübertrager besteht,
in mindestens einem der Ladezweige des Marx-Generators, welcher mit dem zugeordneten Stufenkondensator eine Funkenstrecke - außer der ausgangsseitigen - überbrückt, ein Impulsübertrager sitzt, dessen Ausgangswicklung während des Ladens als oder mit als Ladespule/-induktivität wirkt und dessen Eingangswicklung an den Impulsgenerator derart angeschlossen ist, dass sich der mit diesem Impulsübertrager beim Zünden/Triggern des Impulsgenerators erzeugte Spannungsimpuls zur Ladespannung des zugeordneten Stufenkondensators addiert und bei entsprechender Polung während des Anstiegs des Spannungsimpulses eine zum Selbstdurchbruch reichende Überspannung an dieser Funkenstrecke erzeugt.

2. Trigger-/Zündeinrichtung nach Anspruch 1, **dadurch gekennzeichnet, dass** die Ladezweige des Marx-Generators jeweils nur eine Ladespule haben und mindestens eine Ladespule davon zum Impulsübertrager ergänzt ist.

3. Trigger-/Zündeinrichtung nach Anspruch 1, **dadurch gekennzeichnet, dass** die Ladezweige des Marx-Generators jeweils einen Ladewiderstand haben und in mindestens einem Ladezweig ein Impulsübertrager mit seiner Ausgangswicklung direkt in Reihe oder parallel zum Ladewiderstand sitzt.

4. Trigger-/Zündeinrichtung nach einem der Ansprüche 2 und 3, **dadurch gekennzeichnet, dass** die beiden, je an einem Anschluss einer Funkenstrecke ansetzenden Ladezweige je einen Impulsübertrager eingebaut haben.

5. Trigger-/Zündeinrichtung nach Anspruch 4, **dadurch gekennzeichnet, dass** die Eingangswicklung der beiden Impulsübertrager zueinander in Reihe liegen und an einen gemeinsamen Impulsgenerator angeschlossen sind.

6. Trigger-/Zündeinrichtung nach Anspruch 4, **dadurch gekennzeichnet, dass** die Eingangswicklung der beiden Impulsübertrager zueinander parallel liegen und an einen gemeinsamen Impulsgenerator angeschlossen sind.

7. Trigger-/Zündeinrichtung nach Anspruch 4, **dadurch gekennzeichnet, dass** die Eingangswicklung der beiden Impulsübertrager an je einen Impulsgenerator angeschlossen ist.

8. Trigger-/Zündeinrichtung nach einem der Ansprüche 5 bis 7, **dadurch gekennzeichnet, dass** der Impulsgenerator elektrisch mit einer Steuereinrichtung verbunden ist.

9. Trigger-/Zündeinrichtung nach einem der Ansprüche 5 bis 7, **dadurch gekennzeichnet, dass** der Impulsgenerator über eine Lichtleitfaser mit einer Steuereinrichtung verbunden ist.

10. Trigger-/Zündeinrichtung nach einem der vorangehenden Ansprüche, **dadurch gekennzeichnet, dass** der Impulsgenerator und die angeschlossene/n Eingangswicklung/en eine Stromquelle sind und der Strom durch die Stromquelle schnell abschaltbar ist.

11. Trigger-/Zündeinrichtung nach einem der Ansprüche 1 bis 9, **dadurch gekennzeichnet, dass** der Impulsgenerator eine Spannungsquelle ist und der Ausgangswicklung des Impulsübertragers eine Drosselspule in Reihe geschaltet ist.

12. Trigger-/Zündeinrichtung nach Anspruch 11, **dadurch gekennzeichnet, dass** die Spannungsquelle ein Kondensator mit Schalter oder ein in der Leistung gegenüber dem zu betreibenden Marx-Generator kleiner Marx-Generator ist.

13. Trigger-/Zündeinrichtung nach einem der vorangehenden Ansprüche, **dadurch gekennzeichnet, dass** der Wickelsinn der eingangsseitigen Wicklung am Impulsübertrager so angelegt ist, dass die durch den Anstieg des Entladestromes des Marx-Generators in der Eingangswicklung induzierte Spannung der durch die in der Ausgangswicklung induzierten Spannung entgegengerichtet ist.

## Claims

1. Trigger/ignition device on a Marx generator which comprises n step capacitors - n is natural and greater than 1 - the same number of switches/spark gaps and 2(n-1) charging branches, the spark gaps of which Marx generator operate in self-breakthrough mode,
**characterised in that**
the trigger/ignition device comprises at least one pulse transmitter which is connected to a pulse generator,
a pulse transmitter is situated in at least one of the charging branches of the Marx generator which bridges a spark gap - apart from that of the output-side - with the associated step capacitor, the output winding of which pulse transmitter operates during charging as or with as charging coil/inductance and the input winding of which is connected to the pulse generator such that the voltage pulse which is generated with this pulse transmitter during ignition/triggering of the pulse generator is added to the charge voltage of the associated step capacitor and, at a corresponding polarity during the increase of the voltage pulse, produces an excess voltage which is sufficient for the self-breakthrough at this spark gap.

2. Trigger/ignition device according to claim 1, **characterised in that** the charging branches of the Marx generator have respectively only one charging coil and at least one charging coil thereof is a supplement to the pulse transmitter.

3. Trigger/ignition device according to claim 1, **characterised in that** the charging branches of the Marx generator have respectively one charge resistance and, in at least one charging branch, a pulse transmitter with the output winding thereof is situated directly in series or parallel to the charging resistance.

4. Trigger/ignition device according to one of the claims 2 and 3, **characterised in that** the two charging branches, respectively fitted at one connection of a spark gap, have incorporated respectively one pulse transmitter.

5. Trigger/ignition device according to claim 4, **characterised in that** the input winding of the two pulse transmitters are situated in series relative to each other and are connected to a common pulse generator.

6. Trigger/ignition device according to claim 4, **characterised in that** the input winding of the two pulse transmitters are situated in parallel relative to each other and are connected to a common pulse generator.

7. Trigger/ ignition device according to claim 4, **characterised in that** the input winding of the two pulse transmitters is connected respectively to one pulse generator.

8. Trigger/ignition device according to one of the claims 5 to 7, **characterised in that** the pulse generator is connected electrically to a control device.

9. Trigger/ignition device according to one of the claims 5 to 7, **characterised in that** the pulse generator is connected to a control device via a light-conducting fibre.

10. Trigger/ignition device according to one of the preceding claims, **characterised in that** the pulse generator and the connected input winding/s are a current source and the current can be switched off rapidly via the current source. ,

11. Trigger/ ignition device according to one of the claims 1 to 9, **characterised in that** the pulse generator is a voltage source and a reactive coil is connected in series to the output winding of the pulse transmitter.

12. Trigger/ ignition device according to claim 11, **characterised in that** the voltage source is a capacitor with a switch or a Marx generator which is small in output relative to the Marx generator which is to be operated.

13. Trigger/ ignition device according to one of the preceding claims, **characterised in that** the winding direction of the input-side winding at the pulse transmitter is designed such that the voltage induced in the input winding by the increase in the discharge current of the Marx generator acts in the opposite direction to the voltage induced by that in the output winding.

## Revendications

1. Installation de déclenchement/allumage d'un générateur de Marx composé de n condensateurs d'étages (n est un nombre naturel supérieur à 1) et d'autant de commutateurs/éclateurs et de 2 (n-1) branches de charge, et dont les éclateurs fonctionnent par auto-amorçage,
**caractérisée en ce que**
l'installation de déclenchement/d'allumage se compose d'au moins un transformateur d'impulsion branché sur un générateur d'impulsion,
dans au moins l'une des branches de charge du générateur de Marx qui court-circuite avec le transformateur d'étage associé, un éclateur (à l'exception de celui du côté de sortie), il y a un transformateur d'impulsion dont l'enroulement de sortie fonctionne pendant la charge comme ou avec une bobine de charge/inductance, et dont l'enroulement d'entrée est relié au générateur d'impulsion de façon que l'impulsion de tension générée avec ce transformateur d'impulsion lors du déclenchement/ allumage du générateur d'impulsion, s'additionne à la tension de charge du condensateur d'étage, associé et que pour une polarité appropriée, pendant la montée de l'impulsion de tension, elle génère une surtension suffisante à l'auto-amorçage de cet éclateur.

2. Installation de déclenchement/allumage selon la revendication 1,
**caractérisée en ce que**
les branches de charge du générateur de Marx ont chacune seulement une bobine de charge et au moins l'une des bobines de charge est complétée par un transformateur d'impulsion.

3. Installation de déclenchement/allumage selon la revendication 1,
**caractérisée en ce que**
les branches de charge du générateur de Marx ont chacune une résistance de charge et dans au moins une branche de charge, un transformateur d'impulsion est en série ou en parallèle avec la résistance de charge, directement par son enroulement de sortie.

4. Installation de déclenchement/allumage selon l'une quelconque des revendications 2 et 3,
**caractérisée en ce que**
les deux branches de charge reliées chaque fois à un branchement d'un éclateur, comportent chacune un transformateur d'impulsion.

5. Installation de déclenchement/allumage selon la revendication 4,
**caractérisée en ce que**
l'enroulement d'entrée des deux transformateurs d'impulsion est en série et est relié à un générateur d'impulsion, commun.

6. Installation de déclenchement/ allumage selon la revendication 4,
**caractérisée en ce que**
l'enroulement d'entrée des deux transformateurs d'impulsion est en parallèle et est relié à un générateur d'impulsion commun.

7. Installation de déclenchement/allumage selon la revendication 4,
**caractérisée en ce que**
l'enroulement d'entrée des deux transformateur d'impulsion est relié chaque fois à un générateur d'impulsion.

8. Installation de déclenchement/allumage selon l'une quelconque des revendications 5 à 7,
**caractérisée en ce que**
le générateur d'impulsion est relié électriquement directement à une installation de commande.

9. Installation de déclenchement/allumage selon l'une quelconque des revendications 5 à 7,
**caractérisée en ce que**
le générateur d'impulsion est relié à une installation de commande par une fibre optique.

10. Installation de déclenchement/allumage selon l'une quelconque des revendications précédentes,
**caractérisée en ce que**
le générateur d'impulsion et le ou les enroulements raccordés à celui-ci sont constitués par une source de courant et le courant peut être coupé rapidement par la source de courant.

11. Installation de déclenchement/allumage selon l'une quelconque des revendications 1 à 9,
**caractérisée en ce que**
le générateur d'impulsion est une source de tension et l'enroulement de sortie du transformateur d'impulsion est branché en série avec une inductance.

12. Installation de déclenchement/allumage selon la revendication 11,
**caractérisée en ce que**
la source de tension est un condensateur avec un commutateur, ou un générateur de Marx de puissance plus petite que celle du générateur de Marx utilisé.

13. Installation de déclenchement/allumage selon l'une quelconque des revendications précédentes,
**caractérisée en ce que**
le sens de l'enroulement d'entrée est appliqué au transformateur d'impulsion pour que la montée du courant de décharge du générateur de Marx induise dans l'enroulement d'entrée une tension qui s'oppose à la tension induite dans l'enroulement de sortie.
